## Europäisches Patentamt
## European Patent Office
## Office européen des brevets

(19)

(11) Veröffentlichungsnummer: **0 095 183**
**B1**

(12) **EUROPÄISCHE PATENTSCHRIFT**

(45) Veröffentlichungstag der Patentschrift:
**07.01.88**

(51) Int. Cl.⁴: **H 01 L 29/91**

(21) Anmeldenummer: **83105127.1**

(22) Anmeldetag: **24.05.83**

(54) **Schottky-Leistungsdiode.**

(30) Priorität: **25.05.82 DE 3219606**

(43) Veröffentlichungstag der Anmeldung:
**30.11.83 Patentblatt 83/48**

(45) Bekanntmachung des Hinweises auf die Patenterteilung:
**07.01.88 Patentblatt 88/1**

(84) Benannte Vertragsstaaten:
**DE FR GB IT NL**

(56) Entgegenhaltungen:
**US - A - 4 163 677**
**US - A - 4 167 015**
**US - A - 4 316 201**

**ELECTRONICS LETTERS, Band 16, Nr. 7, März 1980, Seiten 254-256, HITCHIN HERTS, (GB). A. CHRISTOU et al.: "High Performance millimetre Ge-GeAs mixer diode for low l.o. power applications"**

(73) Patentinhaber: **Siemens Aktiengesellschaft Berlin und München, Wittelsbacherplatz 2, D-8000 München 2 (DE)**

(72) Erfinder: **Mitlehner, Heinz, Dr. rer. nat., Hohenzollernstrasse 104, D-8000 München 40 (DE)**
Erfinder: **Koibesen, Bernd, Dr., Leopoldstrasse 136, D-8000 München 40 (DE)**

ACTORUM AG

# Beschreibung

Die vorliegende Erfindung bezieht sich auf eine Schottky-Leistungsdiode mit einem Halbleitersubstrat, mit einer über dem Substrat angeordneten Isolierschicht und einem Schottky-Kontakt, der sich durch ein in der Isolierschicht angebrachtes Fenster erstreckt.

Eine solche Schottky-Leistungsdiode, wie sie beispielsweise in der Zeitschrift «Electronics», February 5, 1976, Seite 85 bis 89 beschrieben worden ist, hat den Vorzug eines im Vergleich zu pn-Dioden geringeren Durchlasswiderstands. Da ihr Leitungsmechanismus anders als bei pn-Leistungsdioden unipolaren Charakter hat, sind ihre Sperrverzögerungszeiten sehr gering, so dass eine Schottky-Leistungsdiode mit hohen Frequenzen im Bereich von z.B. 100 kHz und mehr betrieben werden kann. Nachteilig ist jedoch die relativ geringe maximale Sperrspannung, die in der Grössenordnung von 50 ... 100 V liegt.

Der Erfindung liegt die Aufgabe zugrunde, eine Schottky-Leistungsdiode der eingangs erwähnten Art so weiterzubilden, dass die Sperrspannung auf über 100 V erhöht werden kann. Dabei sollen die Sperrstromverluste minimiert und eine Betriebstemperatur bis ca. 180°C zugelassen werden können. Ausserdem soll der Spannungsabfall im Duchlassbetrieb kleiner als der einer vergleichbaren pn-Diode bleiben und die Sperrverzögerungszeit im Nanosekunden-Bereich liegen.

Diese Aufgabe wird gelöst durch eine zwischen Halbleitersubstrat und Schottky-Kontakt liegende halbisolierende Zwischenschicht mit einer Dichte an lokalisierten Zuständen von $10^{17}$ bis $10^{20}$ $eV^{-1} cm^{-3}$, mit einem Bandabstand, der grösser ist als beim Halbleitersubstrat, sowie mit einem spezifischen Widerstand zwischen $10^5$ und $10^{11}$ Ohm cm.

Zwischen dem Halbleitersubstrat und dem Schottky-Kontakt liegende Zwischenschichten aus Germanium bzw. hoch p-dotiertem amorphen Silicium sind bereits bei GaAs-Mikrowellendioden bzw. bei a-Si-Solarzellen bekannt (vgl. z.B. Electronic Letters, Vol.16, No.7, März 1980, S.254–256 bzw. US-A-4 163 677). Es handelt sich dabei jedoch nicht um Leistungsbauelemente und die bekannten Zwischenschichten weisen nicht die beanspruchten Merkmale auf.

Weiterbildungen der Erfindung sind Gegenstand der Unteransprüche.

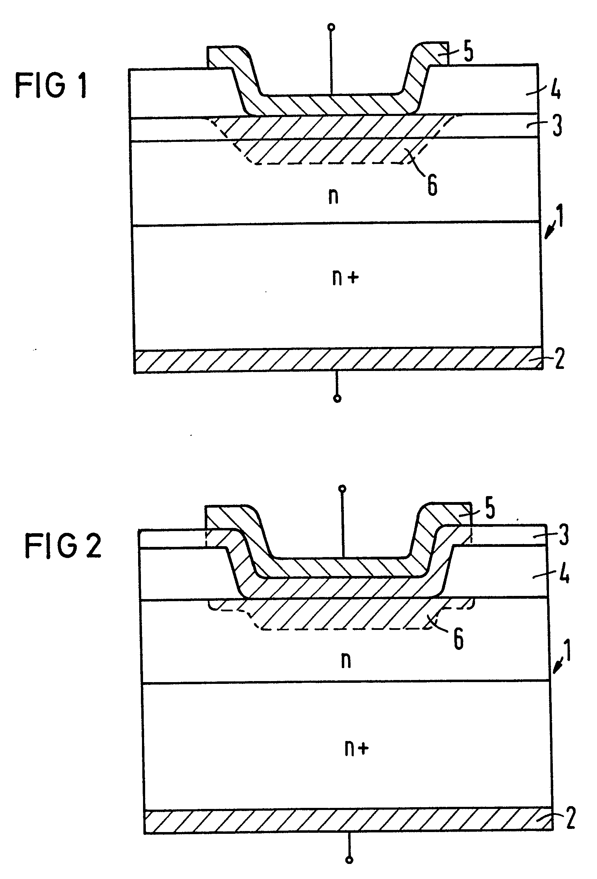

Die Erfindung wird an Hand zweier Ausführungsbeispiele in Verbindung mit der Fig. 1 und 2 näher erläutert:

Die in Fig. 1 dargestellte Schottky-Leistungsdiode hat ein Substrat 1, das z.B. aus zwei Schichten unterschiedlich stark n-dotierten monokristallinen Siliciums besteht. Das Substrat ist mit einem ohmschen Katodenkontakt 2 verbunden. Auf der schwächer dotierten Schicht des Substrats 1 ist ganzflächig eine Zwischenschicht 3 mit einer Dikke von 10 bis 50 nm angeordnet. Diese Zwischenschicht besteht aus einem Material mit einer Dichte an lokalisierten Zuständen von $10^{17}$ bis $10^{20}$ $eV^{-1} cm^{-3}$ im verbotenen Band. Dieses Material muss ausserdem einen grösseren Bandabstand als das Halbleitersubstrat und einen spezifischen Widerstand zwischen $10^5$ und $10^{11}$ Ohm cm haben. Sein Ferminiveau liegt wenigstens ungefähr in Bandmitte. Aufgrund seines Widerstands ist es als halbisolierendes Material zu bezeichnen. Für die Zwischenschicht 3 kommt vorzugsweise amorphes Silicium in Frage. Es sind jedoch auch andere Stoffe mit den oben beschriebenen Eigenschaften, z.B. amorphes Germanium, möglich. Die Zwischenschicht 3 ist mit einer Isolierschicht 4 bedeckt, die beispielsweise aus Siliciumdioxid $SiO_2$ besteht. In der Isolierschicht 4 ist ein Fenster angebracht, in dem ein Schottky-Kontakt 5 sitzt. Dieser Schottky-Kontakt kontaktiert die Zwischenschicht 3.

In Fig. 2 ist eine Schottky-Leistungsdiode gezeigt, bei der die Zwischenschicht 3 ausserhalb des Fensters über der Islolierschicht 4 liegt. Innerhalb des Fensters liegt die Zwischenschicht 3 auf dem Substrat 1 auf.

In beiden Ausführungsbeispielen ist der Schottky-Kontakt über den Rand des Fensters hinausgezogen. Dies ist nicht zwingend, hat aber vorteilhafte Auswirkungen auf die Krümmung der Raumladungszone im Substrat.

Bei Anlegen einer Sperrspannung entsteht eine Raumladungszone 6 (schraffiert), deren Grenze gestrichelt gezeichnet ist. Diese Raumladungszone wird in der Zwischenschicht 3 an den lokalisierten Zuständen aufgebaut und erstreckt sich bis in das Substrat. In der Zwischenschicht wird ein Teil der Sperrspannung abgebaut, so dass die Substratdotierung entsprechend erhöht werden kann.

Bei gleicher Dotierung können höhere Sperrspannungen erreicht werden. Die oben erwähnten Eigenschaften der Zwischenschicht führen zu einer Erhöhung und Verbreiterung der Potentialbarriere. Dadurch können Leckströme infolge Tunnels durch die Barriere besser unterdrückt werden. Unterstützt wird die effektive Barrierenerhöhung durch die sogennante Heterojunction zwischen Substrat 1 und Zwischenschicht 3. Der Bandabstand z.B. in amorphem Silicium ist mit 1,6 eV deutlich grösser als der des kristallinen Siliciums mit 1,1 eV. Der Einfluss der Grenzflächenzustände im einkristallinen Substrat auf das Sperrstromverhalten der Schottky-Diode wird durch die lokalisierten Zustände in der Zwischenschicht vor dem Metallkontakt wirkungsvoll unterdrückt. Damit wird die Sperrkennlinie flacher und geht steil in den Avalanche-Durchbruch.

Im Ausführungsbeispiel nach Fig. 1 hat die halbisolierende Zwischenschicht 3 noch den Vorteil, dass sie als Passivierung der kritischen Randgebiete am Ende der schraffiert dargestellten Raumladungszone 6 wirkt. Instabilitäten infolge sich ändernder Raumladungszonenkrümmung werden verhindert.

Bei anliegender Durchlassspannung ist der Strom durch Drift und Diffusion gesteuert und wird nicht als Rekombinationsstrom geführt. Der Diodenfaktor liegt daher nahe bei 1. Ausschlaggebend für dieses Verhalten ist die dünne Zwischenschicht ($<< 1$ μm) und die hohe Zustandsdichte in dieser Schicht. Das heisst, im Durchlass werden die über das verbotene Band verteilten Zustände mit Ladungsträgern überschwemmt, so dass der Durchlasswiderstand klein wird. Eine hohe Potentialbarriere verschlechtert dieses Durchlassverhalten. Der Durchlassspannungsabfall bleibt jedoch in jedem Fall unter dem bipolarer pn-Dioden. Infolge der hohen Zustandsdichte in der Zwischenschicht 3 ist die Lebensdauer der Ladungsträger sehr kurz. Versuche haben ergeben, dass eine solche Diode bei einer Frequenz von 1 MHz ihre Sperrfähigkeit behält.

Die Zwischenschicht 3 kann z.B. durch Aufdampfen oder durch Glimmentladung aufgebracht werden. Der spezifische Widerstand beim aufgedampften amorphen Silicium lässt sich durch einen Sauerstoffgehalt des amorphen Siliciums von 2 ... 40 Atomprozent in den angegebenen weiten Grenzen von $10^5$ ... $10^{11}$ Ohm regeln. Der Sauerstoffgehalt kann hier während des Bedampfens durch einen entsprechend eingestellten Sauerstoff-Partialdruck im Abscheidungsgefäss eingestellt werden.

Wird das amorphe Silicium durch Glimmentladung abgeschieden, so lässt sich der spezifische Widerstand in den angegebenen weiten Grenzen durch die Wahl der Abscheidetemperatur zwischen 150 und 350 °C und die Beifügung von 5 ... 20 Atomprozent Wasserstoff einstellen. Der Wasserstoffgehalt wird in diesem Fall durch die Glimmentladungsleistung, den Gasdruck und die Substrattemperatur eingestellt. Als Schichtdicke für die Zwischenschicht 3 kommt der Bereich zwischen 10 nm und 50 nm in Frage.

Eine typische Schottky-Leistungsdiode für eine Sperrspannung über 100 V hat z.B. ein Substrat mit einem spezifischen Widerstand von 20 Ohm cm, einer Dicke der niedriger dotierten Schicht von 50 μm und einen spezifischen Widerstand von $10^7$ bis $10^8$ Ohm cm für die Zwischenschicht 3. Die Dicke der Zwischenschicht beträgt in diesem Fall 30 nm.

Für die Schottky-Kontaktschicht 5 kommen die üblichen Metalle wie z.B. Molybdän, Wolfram, Platin, aber auch Aluminium und Chrom in Frage.

## Patentansprüche

1. Schottky-Leistungsdiode mit einem Halbleitersubstrat (1), mit einer über dem Substrat angeordneten Isolierschicht (4) und einem Schottky-Kontakt (5), der sich durch ein in der Isolierschicht (4) angebrachtes Fenster erstreckt, gekennzeichnet durch eine zwischen Halbleitersubstrat (1) und Schottky-Kontakt (5) liegende halbisolierende Zwischenschicht (3) mit einer Dichte an lokalisierten Zuständen von $10^{17}$ bis $10^{20}$ eV$^{-1}$cm$^{-3}$, mit einem Bandabstand, der grösser ist als beim Halbleitersubstrat, sowie einem spezifischen Widerstand zwischen $10^5$ und $10^{11}$ Ohm cm.

2. Schottky-Leistungsdiode nach Anspruch 1, dadurch gekennzeichnet, dass die Zwischenschicht (3) aus amorphem Silicium und das Substrat (1) aus einkristallinem Silicium besteht.

3. Schottky-Leistungsdiode nach Anspruch 1, dadurch gekennzeichnet, dass die Zwischenschicht (3), aus amorphem Germanium und das Substrat (1) aus einkristallinem Silicium besteht.

4. Schottky-Leistungsdiode nach einem der Ansprüche 1 bis 3, dadurch gekennzeichnet, dass die Zwischenschicht (3) zwischen 10 und 50 nm dick ist.

5. Schottky-Leistungsdiode nach Anspruch 2, dadurch gekennzeichnet, dass die amorphe Siliciumschicht (3) aus aufgedampftem Silicium besteht, das 2 bis 40 Atomprozent Sauerstoff enthält.

6. Schottky-Diode nach Anspruch 2, dadurch gekennzeichnet, dass die amorphe Siliciumschicht (3) durch Glimmentladung abgeschieden ist und 5 bis 20 Atomprozent Wasserstoff enthält.

7. Schottky-Diode nach einem der Ansprüche 1 bis 6, dadurch gekennzeichnet, dass die Zwischenschicht (3) ganzflächig auf dem Substrat (1) aufliegt und von der Isolierschicht (4) bedeckt ist.

8. Schottky-Diode nach einem der Ansprüche 1 bis 6, dadurch gekennzeichnet, dass die Zwischenschicht (3) über der Isolierschicht (4) innerhalb des in der Isolierschicht (4) angebrachten Fensters auf dem Substrat (1) liegt.

9. Schottky-Diode nach Anspruch 7 oder 8, dadurch gekennzeichnet, dass der Schottky-Kontakt (5) über den Rand des Fensters hinübergreift.

## Claims

1. A Schottky power diode comprising a semiconductor substrate (1), with an insulating layer (4) arranged above the substrate and a Schottky contact (5) which extends through a window in the insulating layer (4), characterised by semi-insulating intermediate layer (3) arranged between the semiconductor substrate (1) and the Schottky contact (5) and which has a density of localised states of $10^{17}$ to $10^{20}$ eV$^{-1}$cm$^{-3}$, a band spacing which is greater than that in the semiconductor substrate, and a specific resistance of between $10^5$ and $10^{11}$ Ohm cm.

2. A Schottky power diode as claimed in Claim 1, characterised in that the intermediate layer (3) consists of amorphous silicon and the substrate (1) consists of monocrystalline silicon.

3. A Schottky power diode as claimed in Claim 1, characterised in that the intermediate layer (3) consists of amorphous germanium and the substrate (1) consists of monocrystalline silicon.

4. A Schottky power diode as claimed in one of Claims 1 to 3 , characterised in that the intermediate layer (3) has a thickness of between 10 and 50 nm.

5. A Schottky power diode as claimed in Claim 2, characterised in that the amorphous silicon layer (3) consists of vapour-deposited silicon which contains 2 to 40 atom percent of oxygen.

6. A Schottky diode as claimed in Claim 2, characterised in that the amorphous silicon layer (3) is deposited by means of a glow discharge and contains 50 to 20 atom percent of hydrogen.

7. A Schottky diode as claimed in one of Claims 1 to 6, characterised in that the intermediate layer (3) is applied to the entire surface of the substrate (1) and is covered by the insulating layer (4).

8. A Schottky diode as claimed is one of Claim 1 to 6, characterised in that the intermediate layer (3) is arranged above the insulating layer (4) and within the window contained in the insulating layer (4), lies on the substrate (1).

9. A Schottky diode as claimed in Claim 7 or 8, characterised in that the Schottky contact (5) extends beyond the edge of the window.

## Revendications

1. Diode Schottky de puissance comportant un substrat semiconducteur (19) muni d'une couche isolante (4) disposée sur le substrat et un contact Schottky (5), que s'étend à travers une fenêtre ménagée dans la couche isolante (4), caractérisé par une couche intercalaire semi-isolante (3) située entre le substrat semiconducteur (1) et le contact de Schottky (5) et possédant une densité en états localisés comprise entre $10^{17}$ et $10^{20}$ $eV^{-1}cm^{-3}$, un intervalle de bande qui est plus important que dans le substrat semiconducteur, ainsi qu'une résistance spécifique comprise entre $10^5$ et $10^{11}$ohms.cm.

2. Diode Schottky de puissance suivant la revendication 1, caractérisée par le fait que la couche intercalaire (3) est constituée par du silicium amorphe et que le substrat (1) est constitué par du silicium monocristallin.

3. Diode Schottky de puissance suivant la revendication 1, caractérisée par le fait que la couche intercalaire (3) est constituée par du germanium amorphe et que le substrat (1) est constitué par du silicium monocristallin.

4. Diode Schottky de puissance suivant l'une des revendications 1 à 3, caractérisée par le fait que la couche intercalaire (3) possède une épaisseur comprise entre 10 et 50 nm.

5. Diode Schottky de puissance suivant la revendication 2, caractérisée par le fait que la couche de silicium amorphe (3) est constituée par du silicium déposé par évaporation, qui contient 2 à 40% d'atomes d'oxygène.

6. Diode Schottky suivant la revendication 2, caractérisée par le fait que la couche de silicium amorphe (3) est déposée au moyen d'une décharge à effluve et contient 5 à 20% d'atomes.

7. Diode Schottky suivant l'une des revendications 1 à 6, caractérisée par le fait que la couche intercalaire (3) est disposée sur toute la surface du substrat (1) et est recouverte par la couche isolante (4).

8. Diode Schottky suivante l'une des revendications 1 à 6, caractérisée par le fait que la couche intercalaire (3) est située au-dessus de la couche isolante (4) et à l'intérieur de la fenêtre, ménagée dans la couche isolante (4), sur le substrat (1).

9. Diode Schottky suivant la revendication 7 ou 8, caractérisée par le fait que le contact Schottky (5) s'étend au-delà du bord de la fenêtre.

**FIG 1**

n

n +

**FIG 2**

n

n+